# EUROPEAN PATENT APPLICATION

(11) **EP 1 793 306 A2**
(43) Date of publication of application: **06.06.2007**
(21) Application number: 06077062.5
(22) Date of filing: 20.11.2006
(51) Int. Cl.: G06F 1/20

(54) **Low profile liquid cooled server heat sink**

(30) Priority: 01.12.2005 US 291392
(71) Applicant: Delphi Technologies, Inc., Troy, Michigan 48007 (US)
(72) Inventor: Bhatti, Mohinder Singh, Amherst, NY 14221 (US); Reyzin, Ilya, Williamsville, NY 14221 (US); O'Dwyer, Luke E., Getzville, NY 14068 (US)
(74) Representative: Denton, Michael John

(57) **Abstract**

A computer assembly (**20**) including a casing (**22**) having a bottom (**24**) and end walls (**26**) and side walls (**28**) and a lid (**30**) and a variety of computer components are supported on the bottom (**24**). A partition (**38**) extends between the side walls (**28**) and a plurality of fans is disposed in the partition (**38**) for moving air through perforations (**32**) in the end walls (**26**). A heat exchanger (**44**) includes fins (**48**) and each fan has a central hub (**52**) and fan blades extending radially therefrom. In the embodiment of Figures 1 and 2, the fans move air into said fins (**48**) and a flow straightener (**56**) is disposed between the hub (**52**) of each fan and the fins (**48**) for straightening flow downstream of the hub (**52**) prior to entering said fins (**48**). In the embodiment of Figures 3 and 4, the fans move air through the fins (**48**) and into a flow deflector (**58**) over each hub (**52**) of the fan for diverting flow from the fins (**48**) and around the hubs (**52**) prior to entering the fans.

## Description

### TECHNICAL FIELD

A computer assembly and more particularly to a casing enclosing a plurality of computer components with a liquid coolant system for cooling a computer chip.

### BACKGROUND OF THE INVENTION

The invention relates to a computer assembly including a casing having a bottom and end walls and side walls and a lid with perforations in the end walls for air flow through the casing to cool the computer components. A partition extends between the side walls and spaced from the end walls for establishing a first compartment on one side and a second compartment on the other side and a plurality of fans are disposed in the partition for moving air through the perforations and through the compartments. A heat exchanger is disposed in the second compartment and includes fins disposed extending parallel to the side walls and the fans each have a central hub and fan blades extending radially therefrom.

### SUMMARY OF THE INVENTION

The invention provides for a flow control disposed between the fins and the hub of each fan for reconciling air flow around the hub with straight flow through the fins.

### BRIEF DESCRIPTION OF THE DRAWINGS

Other advantages of the present invention will be readily appreciated, as the same becomes better understood by reference to the following detailed description when considered in connection with the accompanying drawings wherein:
Figure 1 is a perspective view of a first embodiment of the invention;
Figure 2 is a perspective view of the heat exchanger and fan arrangement of the first embodiment;
Figure 3 is a perspective view of a second embodiment of the invention; and
Figure 4 is a perspective view of the heat exchanger and fan arrangement of the second embodiment.

### DESCRIPTION OF THE PREFERRED EMBODIMENTS

Referring to the figures, wherein like numerals indicate corresponding parts throughout the several views, a computer assembly **20** is generally shown.

The assembly **20** includes a casing **22** generally indicated which is made up of a bottom **24** and end walls **26** and side walls **28** and a lid **30.** The end walls **26** have perforations **32** therein for air flow through the casing **22.**

A plurality of computer components are supported on the bottom **24,** including various circuit boards **34** and electronic boxes **36.**

A partition **38** extends between the side walls **28** and is spaced from the end walls **26** for establishing a first compartment on one side and a second compartment on the other side.

A cold plate **40** is disposed on the bottom **24** in the first compartment and an electronic chip is disposed on the cold plate **40** for cooling by the cold plate **40.** More specifically, a liquid coolant is circulated through the cold plate **40** by a pump **42** disposed on the bottom **24** in the second compartment. A heat exchanger **44** is generally indicated and extends along and adjacent to the partition **38** and includes coolant tubes **46** and fins **48** disposed about the tubes and extending parallel to the side walls **28.** The fins **48** establish a direction of flow perpendicular to the end walls **26** and parallel to the side walls **28,** i.e., straight flow. A plurality of coolant conduits **50** interconnect or establish fluid communication between the cold plate **40** and the pump **42** and the tubes of the heat exchanger **44** for circulating coolant fluid through the pump **42** and the cold plate **40** and the heat exchanger **44** for cooling the coolant fluid in the heat exchanger **44** and extracting heat from the electronic chip at the cold plate **40.**

The partition **38,** via a plurality of housings, defines a plurality of opening disposed in side by side relationship to one another along the partition **38.** An array of fans are disposed in side-by-side relationship to one another in the openings defined by the housings in the partition **38** for moving air through the perforations **32** in the end walls **26** and through the compartments. Each of the fans has a central hub **52** and fan blades extend radially therefrom, each hub **52** being centrally supported in an opening by a plurality of spokes **54** extending radially from each hub **52.**

The heat exchanger **44** extends along and adjacent to the array of fans in the second compartment.

The invention includes a flow control disposed between the array of fans and the fins **48** for reconciling air flow around each of the hubs **52** with straight flow through the fins **48.**

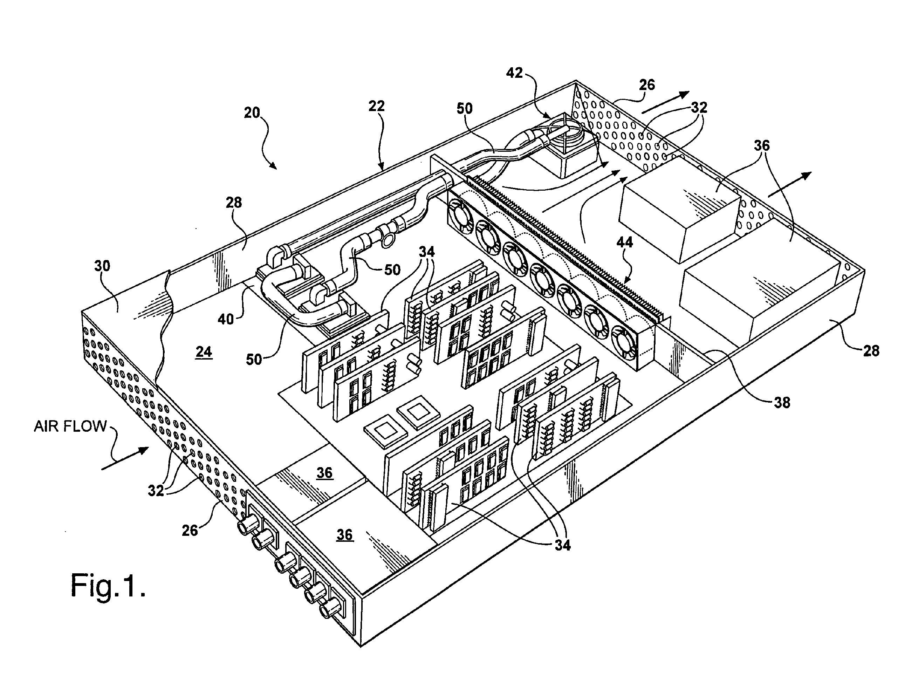

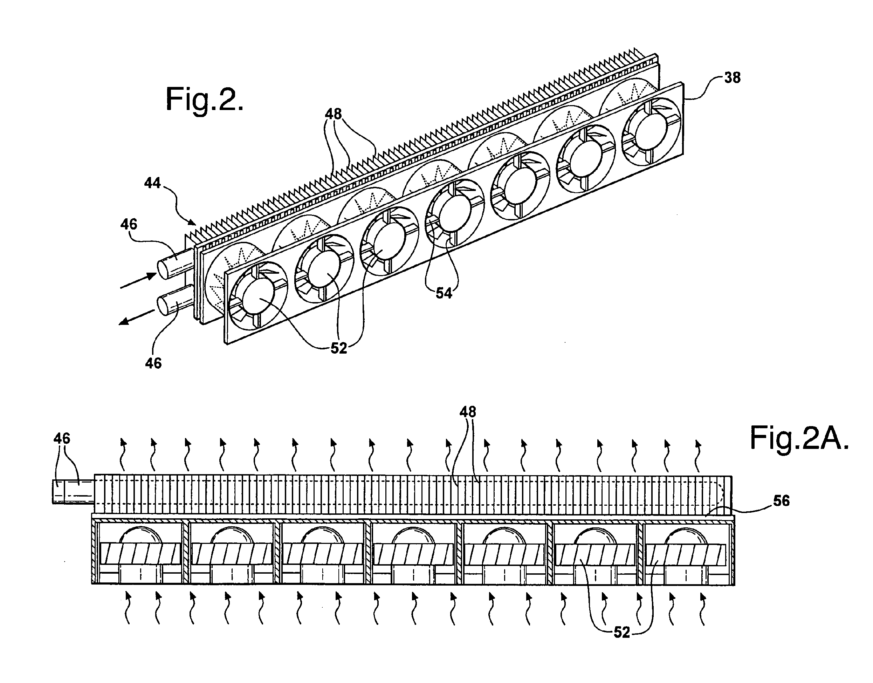

In the embodiment of Figures 1 and 2, the fans move air through the first compartment and into the fins **48** in the second compartment and the flow control includes a flow straightener **56** between the hub **52** of the fan and the fins **48** for straightening flow downstream of the hub **52** prior to entering the fins **48.**

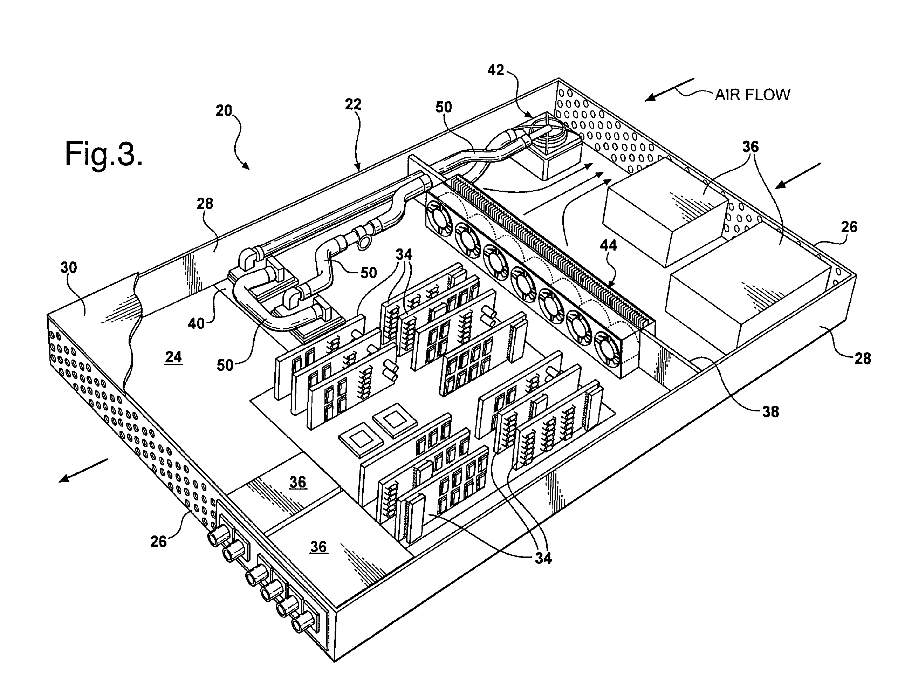

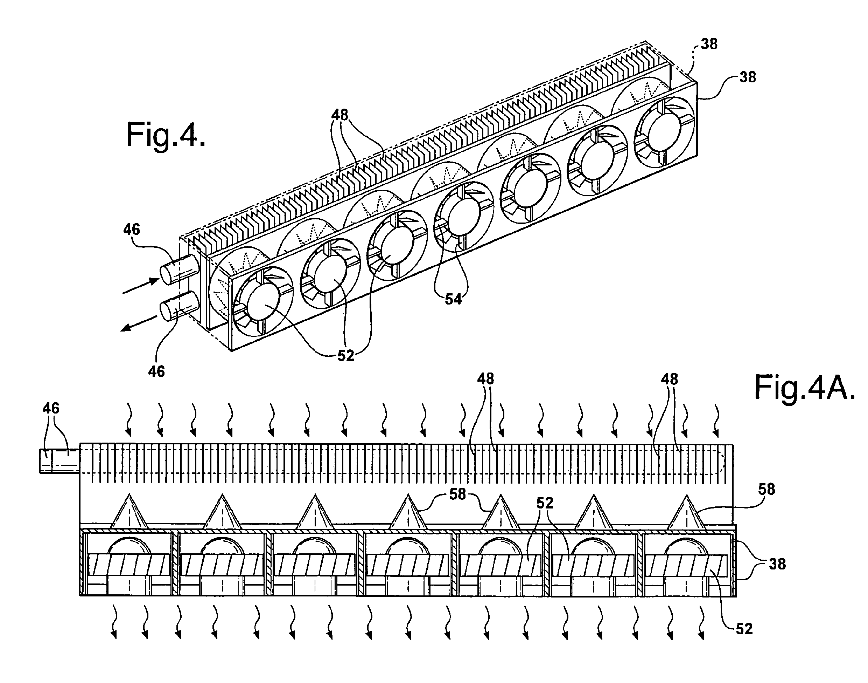

In the embodiment of Figures 3 and 4, the fans move air through the second compartment and through the fins **48** and into the first compartment and the flow control includes a flow deflector **58** over the hub **52** of the fan for diverting flow from the fins **48** and around the hub **52** prior to entering the fan. The flow diverter takes the form of a cone having its base disposed over the hub **52.**

Obviously, many modifications and variations of the present invention are possible in light of the above teachings. The invention may be practiced otherwise than as specifically described within the scope of the appended claims, wherein that which is prior art is antecedent to the novelty set forth in the "characterized by" clause. The novelty is meant to be particularly and distinctly recited in the "characterized by" clause whereas the antecedent recitations merely set forth the old and well-known combination in which the invention resides. These antecedent recitations should be interpreted to lid **30** any combination in which the incentive novelty exercises its utility. In addition, the reference numerals in the claims are merely for convenience and are not to be read in any way as limiting.

## Claims

1. A computer assembly **(20)** comprising;
a casing **(22)** having a bottom **(24)** and end walls **(26)** and side walls **(28)** and a lid **(30),**
said end walls **(26)** having perforations **(32)** therein for air flow through said casing **(22),**
computer components supported on said bottom **(24),**
a partition **(38)** extending between said side walls **(28)** and spaced from said end walls **(26)** for establishing a first compartment on one side and a second compartment on the other side,
a fan disposed in said partition **(38)** for moving air through said perforations **(32)** and through said compartments,
a heat exchanger **(44)** in said second compartment and including fins **(48)** disposed extending parallel to said side walls **(28),**
said fan having a central hub **(52)** and fan blades extending radially therefrom, and
**characterized by** a flow control disposed between said fins **(48)** and said hub **(52)** of said fan for reconciling air flow around said hub **(52)** with straight flow through said fins **(48).**

2. An assembly **(20)** as set forth in claim 1 wherein said fan moves air through said first compartment and into said fins **(48)** in said second compartment and said flow control includes a flow straightener **(56)** between said hub **(52)** of said fan and said fins **(48)** for straightening flow downstream of said hub **(52)** prior to entering said fins **(48).**

3. An assembly **(20)** as set forth in claim 1 wherein said fan moves air through said second compartment and through said fins **(48)** and into said first compartment and said flow control includes a flow deflector **(58)** over said hub **(52)** of said fan for diverting flow from said fins **(48)** and around said hub **(52)** prior to entering said fan.

4. A computer assembly **(20)** comprising;
a casing **(22)** having a bottom **(24)** and end walls **(26)** and side walls **(28)** and a lid **(30),**
said end walls **(26)** having perforations **(32)** therein for air flow through said casing **(22),**
computer components supported on said bottom **(24),**
a partition **(38)** extending between said side walls **(28)** and spaced from said end walls **(26)** for establishing a first compartment on one side and a second compartment on the other side,
a cold plate **(40)** disposed on said bottom **(24)** in said first compartment,
an electronic chip disposed on said cold plate **(40)** for cooling by said cold plate **(40),**
a pump **(42)** disposed on said bottom **(24)** in said second compartment,
said partition **(38)** defining a plurality of opening disposed in side by side relationship to one another,
an array of fans disposed in side-by-side relationship to one another in said openings in said partition **(38)** for moving air through said perforations **(32)** and through said compartments,
a heat exchanger **(44)** extending along said array of fans in said second compartment and including coolant tubes **(46)** and fins **(48)** disposed about said tubes and extending parallel to said side walls **(28),**
coolant conduits **(50)** interconnecting said cold plate **(40)** and said pump **(42)** and said tubes of said heat exchanger **(44)** for circulating coolant fluid through said pump **(42)** and said cold plate **(40)** and said heat exchanger **(44)** for cooling the coolant fluid in said heat exchanger **(44)** and extracting heat from said electronic chip at said cold plate **(40),**
each of said fans having a central hub **(52)** and fan blades extending radially therefrom,
a plurality of spokes **(54)** in each of said openings extending radially from said hub **(52)** for supporting each fan in one of said openings, and
**characterized by** a flow control disposed between said array of fans and said fins **(48)** for reconciling air flow around each of said hubs **(52)** with straight flow through said fins **(48).**

5. An assembly **(20)** as set forth in claim 4 wherein said fan moves air through said first compartment and into said fins **(48)** in said second compartment and said flow control includes a flow straightener **(56)** between said hub **(52)** of said fan and said fins **(48)** for straightening flow downstream of said hub **(52)** prior to entering said fins **(48).**

6. An assembly **(20)** as set forth in claim 4 wherein said fan moves air through said second compartment and through said fins **(48)** and into said first compartment and said flow control includes a flow deflector **(58)** over said hub **(52)** of said fan for diverting flow from said fins **(48)** and around said hub **(52)** prior to entering said fan.
